# EUROPÄISCHE PATENTSCHRIFT

(11) **EP 1 481 117 B1**
(45) Veröffentlichungstag und Bekanntmachung des Hinweises auf die Patenterteilung: **24.10.2007**
(21) Anmeldenummer: 03706515.8
(22) Anmeldetag: 15.02.2003
(51) Int. Cl.: C30B 25/14, C23C 16/455, C23C 16/30

(54) **VERFAHREN UND VORRICHTUNG ZUM ABSCHEIDEN VON HALBLEITERSCHICHTEN**
METHOD AND DEVICE FOR DEPOSITING SEMI-CONDUCTOR LAYERS
PROCEDE ET DISPOSITIF POUR DEPOSER DES COUCHES DE SEMI-CONDUCTEUR

(30) Priorität: 22.02.2002 DE 10207461
(43) Veröffentlichungstag der Anmeldung: 01.12.2004
(73) Patentinhaber: Aixtron AG, 52072 Aachen (DE)
(72) Erfinder: JÜRGENSEN, Holger, 52072 Aachen (DE); STRAUCH, Gerd, 52072 Aachen (DE)
(74) Vertreter: Grundmann, Dirk
(86) Internationale Anmeldenummer: PCT/EP2003/001549
(87) Internationale Veröffentlichungsnummer: WO 2003/071011

(56) Entgegenhaltungen:
- WO-A-01/04377
- WO-A-90/10092
- US-A- 5 871 586
- KIM I ET AL: "GROWTH OF INGAASP IN A STAGNATION FLOW VERTICAL REACTOR USING TBP AND TBA" JOURNAL OF CRYSTAL GROWTH, NORTH-HOLLAND PUBLISHING CO. AMSTERDAM, NL, Bd. 195, Nr. 1/4, Dezember 1998 (1998-12), Seiten 138-143, XP000669016 ISSN: 0022-0248
- PATENT ABSTRACTS OF JAPAN vol. 1995, no. 03, 28. April 1995 (1995-04-28) & JP 06 349748 A (FURUKAWA ELECTRIC CO LTD:THE), 22. Dezember 1994 (1994-12-22)
- CHINOY P B ET AL: "MATERIAL CHARACTERIZATION OF GAAS GROWN IN A NOVEL OMVPE REACTOR" SOLAR ENERGY MATERIALS AND SOLAR CELLS, ELSEVIER SCIENCE PUBLISHERS, AMSTERDAM, NL, Bd. 27, Nr. 1, 1. Juni 1992 (1992-06-01), Seiten 1-11, XP000296306 ISSN: 0927-0248
- PATENT ABSTRACTS OF JAPAN vol. 1997, no. 12, 25. Dezember 1997 (1997-12-25) & JP 09 219371 A (NIPPON TELEGR &TELEPH CORP <NTT>), 19. August 1997 (1997-08-19)

## Beschreibung

Die Erfindung betrifft ein Verfahren gemäß Gattungsbegriff des Anspruchs 1.

Der Artikel I. Kim et. al. "Growth of InGaAsP in a stagnation flow vertical reactor using TBP and TBA" beschreibt das Wachstum von InP und InGaAsP unter Verwendung von TBP bzw. TBA in einem shower head-Reaktor, wobei die Höhe der Prozesskammer, also der Abstand zwischen dem Gaseinlassorgan und dem Suszeptor zwischen 1 und 2 cm beträgt. Dort wird die Abhängigkeit der Reproduzierbarkeit der Ergebnisse anhand parasitären Wachstums am shower head diskutiert, da TBP und TBA sich dort thermisch zersetzen können. Dort werden Suszeptoren mit einem Durchmesser von 7,5 cm verwendet. Die Rotationsgeschwindigkeit des Suszeptors soll etwa 600 rpm betragen. Es werden Totalgasflüsse zwischen 5 slm und 12 slm beschrieben.

Der Artikel Percy B. Chinoy et. al. "Material characterization of GaAs grown in a novel OMVPE reactor" beschreibt ebenfalls einen Prozess, bei dem metallorganische Komponenten durch ein Gaseinlassorgan in eine Prozesskammer eingebracht werden. Beschrieben wird dort ein sogenannter "close-spaced, inverted, stagnation flow, OMVPE reactor". Der Durchmesser des Suszeptors soll dort 15 cm betragen. Die Prozesskammerhöhe soll zwischen 0,5 und 2 cm liegen. Die dort beschriebenen Experimente wurden bei einer Prozesskammerhöhe von 1 cm durchgeführt bei einem Totalgasfluss zwischen 6 und 10 slm in einem Druckbereich zwischen 100 und 1000 mbar.

Die US 5,871,586 beschreibt ein Verfahren nebst zugehöriger Vorrichtung. Die von dort her bekannte Vorrichtung besitzt ein Reaktorgehäuse, innerhalb dessen ein drehangetriebener Substrathalter angeordnet ist. Dieser Substrathalter liegt in der Horizontalebene und ist um eine vertikale Achse drehbar. In einem Abstand, der geringer ist als der Radius des Substrathalters, befindet sich oberhalb des Substrathalters ein Gaseinlassorgan. Dieses besitzt eine Gaseinlassfläche, die sich parallel zur Oberfläche des Substrathalters erstreckt und die eine Vielzahl von Gasaustrittsöffnungen aufweist, die in der Art eines Siebes eng beieinander liegend angeordnet sind. Durch die Gasaustrittsöffnungen werden die gasförmigen reaktiven Prozessgase in die Prozesskammer eingeleitet. Um auf einem auf dem Substrathalter liegenden Substrat einen dotierten Mischkristall abzuscheiden, werden durch die Gasaustrittsöffnungen eine metallorganische III-Komponente und ein V-Hydrid hindurchgeleitet und zusätzlich ein Dotierstoff. Es können aber auch mehrere III-Komponenten und/oder V-Komponenten in die Prozesskammer eingeleitet werden, um einen drei- oder mehrkomponentigen Mischkristall auf dem Substrat abzuscheiden. Der Substrathalter wird rückwärtig beheizt, so dass auf der Oberfläche und/oder in der Gasphase oberhalb der Substratoberfläche Reaktionen stattfinden können. Bei diesen Reaktionen soll es sich bevorzugt um pyrolythische Zerlegungsreaktionen handeln. Es muss vermieden werden, dass die Zerlegungsprodukte oder thermisch aktivierte Ausgangsstoffe Addukte bilden. Ferner ist es erforderlich, dass das Wachstum über die gesamte Fläche homogen erfolgt.

In Journal of Crystal Growth 195 (1998) 725-732 werden aufgrund theoretischer Überlegungen gewonnene Parametersätze angegeben, um die Homogenität der Wachstumsrate und die Prozessgasausnutzung zu optimieren. Die Autoren dieses Artikels machen die Prognose, dass sich zur Optimierung dieser Schichteigenschaften geringe Abstände von Substrathalteroberfläche und Gasauslassfläche eignen. Dieser Artikel vermutet die besten Ergebnisse bei Prozesskammerhöhen in einem Bereich zwischen 16 und 25 mm.

Die US 5, 781, 693 befasst sich ebenfalls mit der Abscheidung von Schichten auf einem Substrat, wobei die gasförmigen Ausgangsstoffe vermittels eines duschkopfartigen Gaseinlassorganes in die Gasphase eingebracht werden.

Auch die WO 99/42636 befasst sich mit dem Einbringen gasförmiger Ausgangsstoffe vermittelst eines "Duschkopfes" in die Gasphase.

Duschkopfartige Gaseinlassorgane sind ferner bekannt aus US 6, 086, 677, US 5, 595, 606, US 5, 709, 757 und US 5, 422,139.

Der Erfindung liegt die Aufgabe zugrunde, das eingangs erwähnte Verfahren zur Abscheidung von mindestens drei-komponentigen Halbleiterschichten zu verbessern, so dass die Kristallzusammensetzung der abgeschiedenen Schicht über ihre gesamte Fläche Abweichung von deutlich besser als 1000 ppm (also maximal 100 ppm) besitzt und trotzdem die Parameter Totaldruck, Totalgasfluss und Rotationsgeschwindigkeit des Substrathalters zur weiteren Optimierung weitestgehend frei gewählt werden können.

Gelöst wird die Aufgabe durch die in den Ansprüchen angegebene Erfindung.

Wesentlich für den Erfolg des beanspruchten Verfahrens ist die Limitierung des Abstandes zwischen Substrathalter und Gasauslassfläche auf maximal 75 mm.

Dieser Beschränkung des Abstandes liegt die in Untersuchungen gewonnene Erkenntnis zugrunde, dass die Isothermen-Homogenität innerhalb der Prozesskammer oberhalb des Substrates in der Gasphase oberhalb einer Kammerhöhe von 75 mm stark von dem Maß des Abstandes abhängig ist. Unterhalb von 50 mm ist die Homogenität nicht nur so gut wie überhaupt nicht von Abstand zwischen Substrathalter und Gaseinlassfläche abhängig, sondern stabilisiert sich dort auch auf einem günstigen Niveau. Die Strömung zwischen der Gaseinlassfläche und der Substratebene ist in einem vertikalen Reaktor von der Einlassgeometrie, vom Trägergas und dessen Menge, von der Drehzahl des Substrathalters und von Prozessparametern wie Substrathaltertemperatur, Gasaustrittsflächentemperatur und Totaldruck der Gasphase abhängig. Der Transport der Ausgangsstoffe aus den Gasaustrittsöffnungen zur Oberfläche und das Wachstum der Verbindungshalbleiterkristalle werden durch die Diffusion limitiert. Auf der Oberfläche findet keine chemische Gleichgewichtsreaktion statt. Jedes Molekül, welches zur Oberfläche diffundiert, wird dort vollständig konsumiert und in die Schicht eingebaut. Dieser Transportmechismus wird in der Theorie über Grenzschichtmodelle beschrieben. Oberhalb der Substratoberfläche befindet sich ein aus mehreren Grenzschichten bestehendes Grenzschichtsystem. Durch die mechanischen Gasparameter, wie Dichte, Strömungsgeschwindigkeit und Geometrie der Prozesskammer bildet sich eine Strömungsgrenzschicht. Es gibt ferner die Diffusionsgrenzschicht, die von den Diffusionseigenschaften, insbesondere von der Molekülgröße der einzelnen Gase abhängt. Die Diffusionsgrenzschicht ist diejenige Barriere, oberhalb welcher die Ausgangsstoffe homogen verteilt sein müssen, um einen gleichmäßigen Transport zur Oberfläche zu gewährleisten. Schließlich gibt es die Temperaturgrenzschicht, die in erheblichem Maße von der Geometrie und von den Strömungseigenschaften abhängt.

Oberhalb des Substrates besitzt die Gasphase einen hohen vertikalen Temperaturgradienten. Wegen der sich ändernden relativgeschwindigkeit von Substrathalter zu Gasaustrittsfläche und des sich ändernden Totalgasstromes in Radialrichtung ist dieser Temperaturgradientverlauf stark abhängig von der Radialposition innerhalb der Prozesskammer. Da jeder Ausgangsstoff eine für ihn typische charakteristische Zerlegungsenergie besitzt und diese Zerlegungsenergien erheblich voneinander abweichen, haben die Temperaturverläufe in der Gasphase einen erheblichen Einfluss auf den Massentransport der einzelnen Reaktionspartner zur Substratoberfläche. Obwohl die Wachstumsrate über die gesamte Fläche nahezu homogen sein kann, kann sich die Zusammensetzung der Schicht aufgrund eines inhomogenen Temperaturverlaufes in der Ebene erheblich ändern.

Überraschenderweise wurde zusätzlich zu den bisherigen Studien hier in den Untersuchungen gefunden, dass mit geringer werdendem Abstand des Gaseinlassorganes über den Substrathalter die Isothermen zunehmend flacher verlaufen, wobei sich eine brauchbare Isothermenhomogenität bereits bei 75 mm und eine optimale Isothermenhomogenität bei einer Prozesskammerhöhe von < 50 mm einstellt. In diesem Bereich ist die Prozesskammerhöhe sogar völlig unkritisch, da die Isothermenhomogenität sich in diesem Bereich kaum ändert. Da im Bereich < 50 mm Prozesskammerhöhe die Isothermen nahezu absolut flach ausgebildet sind, zerfallen die Ausgangsstoffe, die von oben strahlartig in die Gasphase oberhalb des Substrates einströmen auf der gesamten Fläche nahezu unter radial identischen Bedingungen, so dass nicht nur die Wachstumsrate der Schicht über den gesamten Radius konstant ist, sondern nun auch die Zusammensetzung des Mischkristalls.

Wie weitere Untersuchungen bestätigt haben, führt die Reduzierung der Prozesskammerhöhe auch zu einer Homogenisierung der Wachstumsrate. Die Abweichungen der Schichtdicke über die gesamte abgeschiedene Schicht kann dadurch minimiert werden. Gleichzeitig konnte aber festgestellt werden, dass auch andere, verfahrensrelevante Parameter, nämlich der totale Gasfluss einen erheblichen Einfluss auf die Schichtdickenhomogenität und im Besonderen auf die Effizienz des Prozesses hat. Je niedriger der totale Gasfluss ist und je niedriger die Prozesskammerhöhe ist, desto größer ist der Teil des reaktiven Gasangebots, der in die Schicht eingebaut wird. Theoretisch wäre es deshalb möglich, die Prozesskammerhöhe auf ein Minimum (wenige Millimeter) zu reduzieren. Dies hat aber zur Folge, dass zur Kühlung des Gaseinlasses ein erheblicher Aufwand betrieben werden muss, um zu vermeiden, dass sich die Gasaustrittsfläche des Gaseinlassorganes mit zerlegten Ausgangsstoffen belegt. Auch limitieren die mechanischen Gegebenheiten die Prozesskammerhöhe nach unten.

Die überraschende Erkenntnis, dass die Prozesskammerhöhe erst ab etwa 50 mm einen Einfluss auf die Homogenität der Komposition hat, führt erfindungsgemäß zur Möglichkeit, die übrigen, prozessrelevanten Parameter so zu wählen, dass die Effizienz optimiert ist und gleichzeitig auch die Schichtdicke über dem Substrat homogen verläuft. Es sind Schichtdickenhomogenitäten von unter 1 % erzielbar. Die übrigen Prozessparameter können zufolge dieses überraschenden Ergebnisses bei niedrigen Prozesskammerhöhen unter rein ökonomischen Gesichtspunkten optimiert werden, das heißt Minimierung des Gesamtflusses und Maximierung der Rotationsgeschwindigkeit.

Die Erfindung wird anhand beigefügter grafischer Darstellungen nachfolgend detailreicher erläutert. Es zeigen:
- Fig. 1: das Ergebnis von Untersuchungen, betreffend die Isothermenhomogenität über verschiedene Prozesskammerhöhen,
- Fig. 2: eine Darstellung des Schichtwiderstandes über das beschichtete Substrat, wobei die Linien entlang Zonen gleichen Schichtwiderstandes verlaufen, bei einer Prozesskammerhöhe von 80 mm,
- Fig. 3: eine Darstellung gemäß Figur 2 bei einer Prozesskammerhöhe von 50 mm,
- Fig. 4: eine Darstellung der Fotolumineszenz-Emmisionswellenlängen über das beschichtete Substrat, wobei die Linien entlang Zonen gleicher Wellenlänge verlaufen, bei der Prozesskammerhöhe von 80 mm, wobei der Totalgasfluss 50 slm und die Substrathalterdrehzahl 100 rpm beträgt,
- Fig. 5: eine Darstellung gemäß Fig. 4 bei einer Prozesskammerhöhe von 20 mm, einem Totalgasfluss von 20 slm und einer Substrathalterdrehzahl von 10 rpm,
- Fig. 6: bis 29 durch Simulationsrechnungen gewonnene Isothermenverläufe zwischen der Prozesskammerdecke D und dem Substrathalter S bei verschiedenen Prozesskammerhöhen, Totalgasflüssen und Substrathalterdrehzahlen.

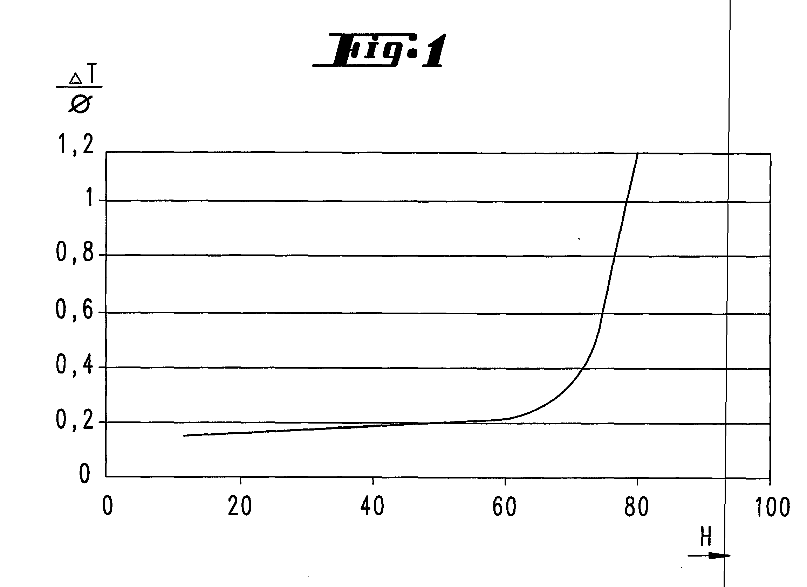

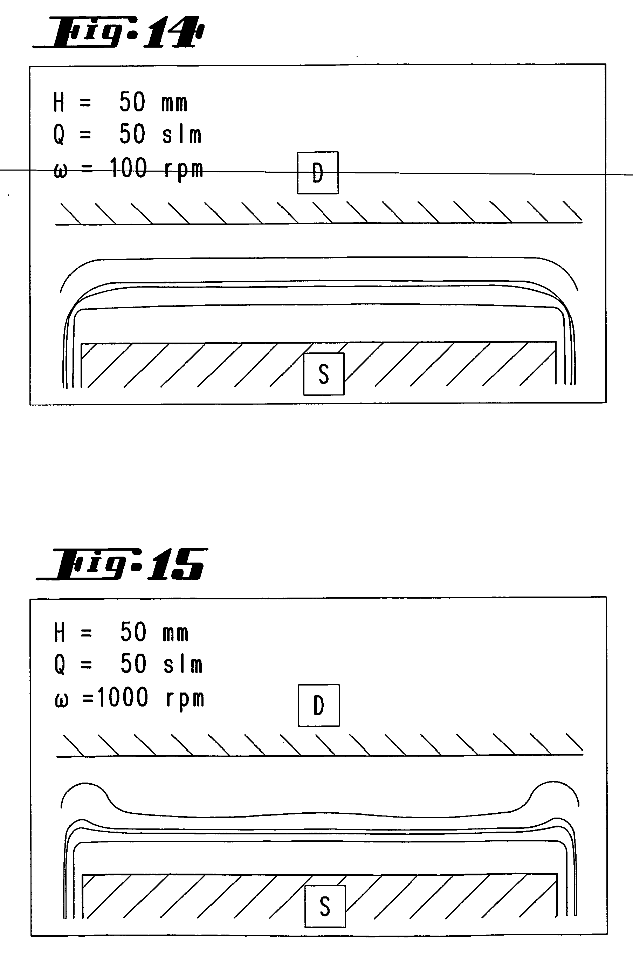

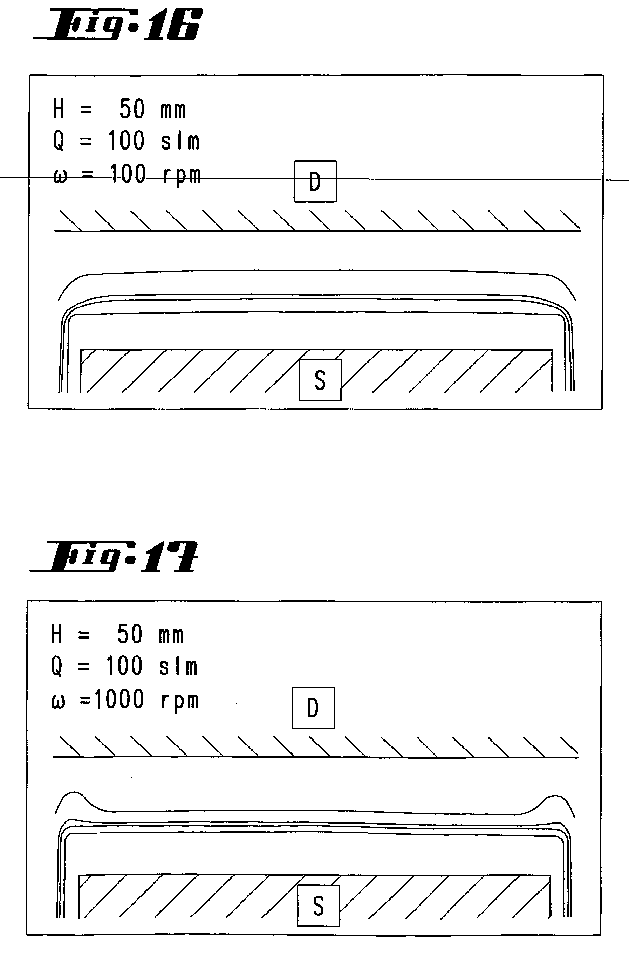

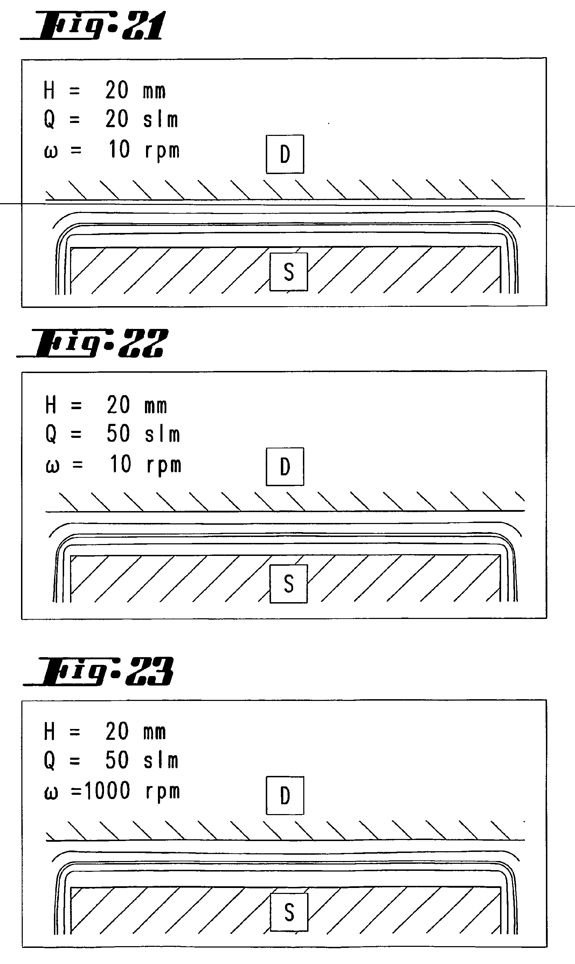

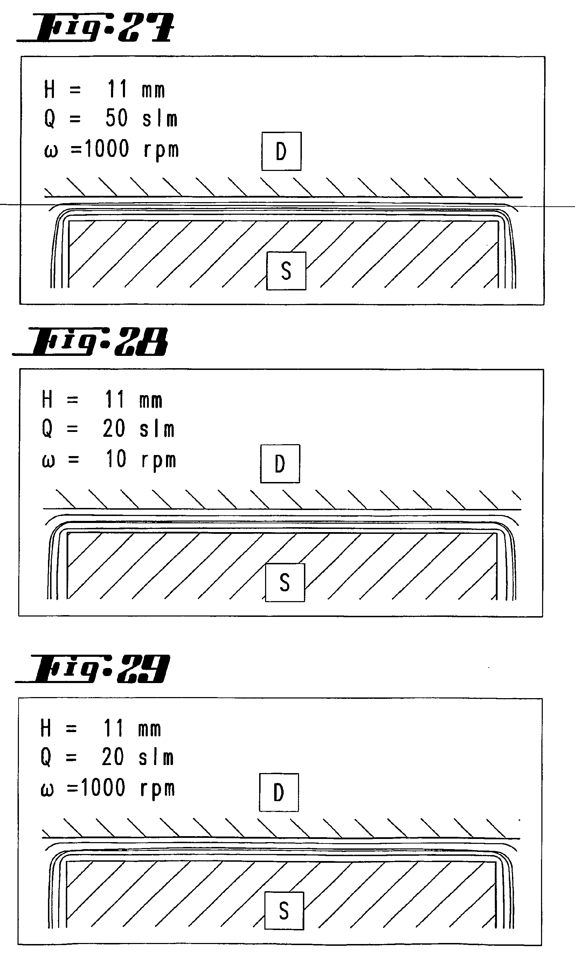

Figur 1 zeigt in Simulationsrechnungen ermittelte Ergebnisse. Es wurden vier optimierte Parametersätze miteinander verglichen. Die Parameter entsprechen denjenigen, die zu den Figuren 11 bis 29 genannt sind.

In der Figur 1 ist bei diesen Parametern die mittlere Abweichung der Isothermenhomogenität vom Mittelwert abgetragen Man erkennt, dass die abweichend vom Mittelwert mit abnehmender Prozesskammerhöhe kleiner wird. Unterhalb von einer Prozesskammerhöhe von 75 mm verläuft der Mittelwert nahezu konstant. Die Isothermen verlaufen in diesem Bereich sehr flach. In einem Bereich oberhalb von 80 mm verlaufen die Isothermen bauchig. Der flache Verlauf der Isothermen zu niedrigen Prozesskammerhöhen hin hat zur Folge, dass die Gasphasenzerlegungsraten der beteiligten Reaktanten überall nahezu gleich ist. Dies hat zur Folge, dass das III/III-Verhältnis oder das V/V-Verhältnis oder der Dotierstoffeinbau in Kristall über die gesamte Schichtfläche nahezu gleichmäßig verläuft.

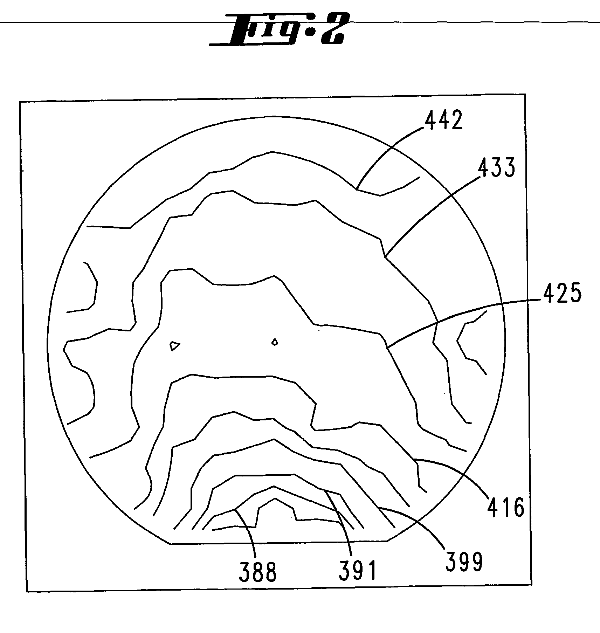

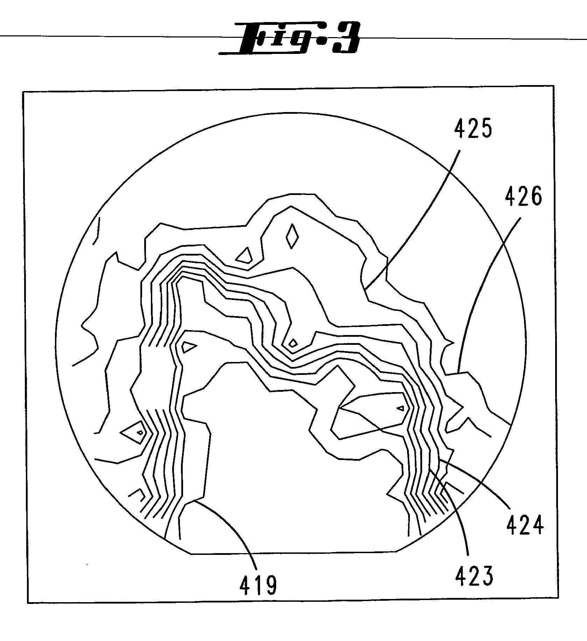

Die Figuren 2 und 3 zeigen die Schichtwiderstände einer AlGaIn P-Schicht, die n-dotiert ist. Die Prozesskammerhöhe von 80 mm bewirkt bei Prozessparametern, wie sie oben angegeben sind, eine inhomogene Ladungsträgerverteilung innerhalb der Schicht. Dies wird durch den inhomogenen Schichtwiderstand repräsentiert. Seine Abweichung vom Mittelwert beträgt hier 5 %. Die Fig. 3 zeigt den Verlauf des Schichtwiderstandes bei einer reduzierten Prozesskammerhöhe, nämlich 50 mm. Auch hier wird der Schichtwiderstand in Ohmsquare angegeben. Die Ladungsträgerverteilung ist deutlich gleichmäßiger. Die Abweichung vom Mittelwert liegt über die gesamte Oberfläche bei 0,5 %.

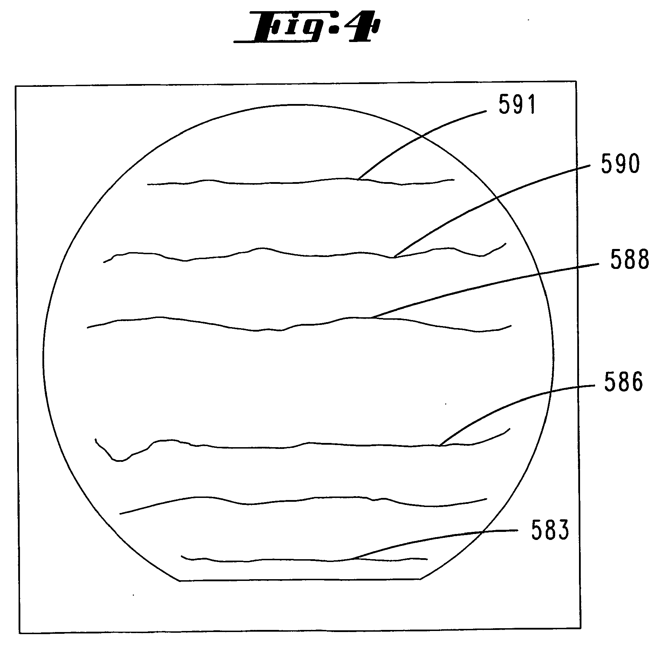

Die Figuren 4 und 5 belegen den Einfluss der Prozesskammerhöhe auf die Homogenität der Schichtzusammensetzung. Es handelt sich dabei um Fotolumineszenzaufnahmen einer AlGaInP-Schicht. Die in Figur 4 dargestellte Oberfläche wurde in einer Prozesskammer mit einer Höhe von 80 mm abgeschieden. Die Standardabweichung vom Mittelwert beträgt dort 0,42 %, das entspricht einer absoluten Variation der Zusammensetzung von 1157 ppm.

Die in Figur 5 dargestellte Schicht wurde bei einer Prozesskammerhöhe von 2.0 mm, einem Totalgasfluss von 20 slm und einer Substrathalterdrehzahl von 10 rpm abgeschieden. Hier beträgt die Standardabweichung über die gesamte Schicht 0,005 %, das entspricht einer absoluten Variation der Zusetzung von 1000 ppm.

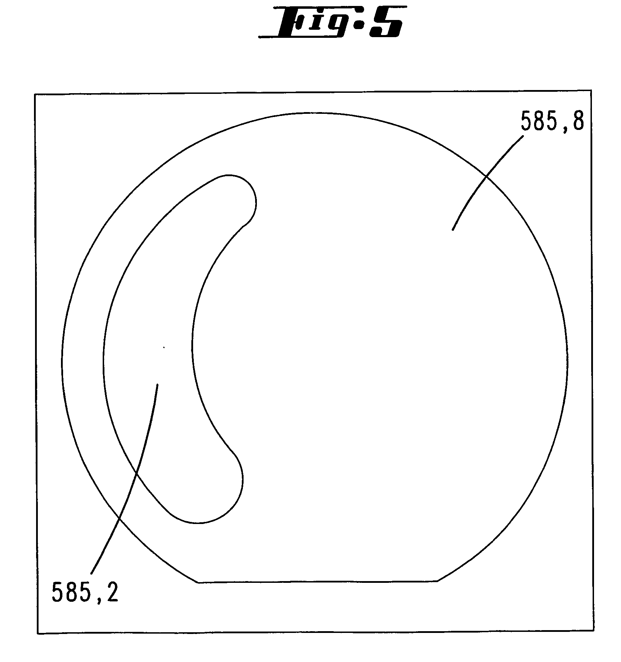

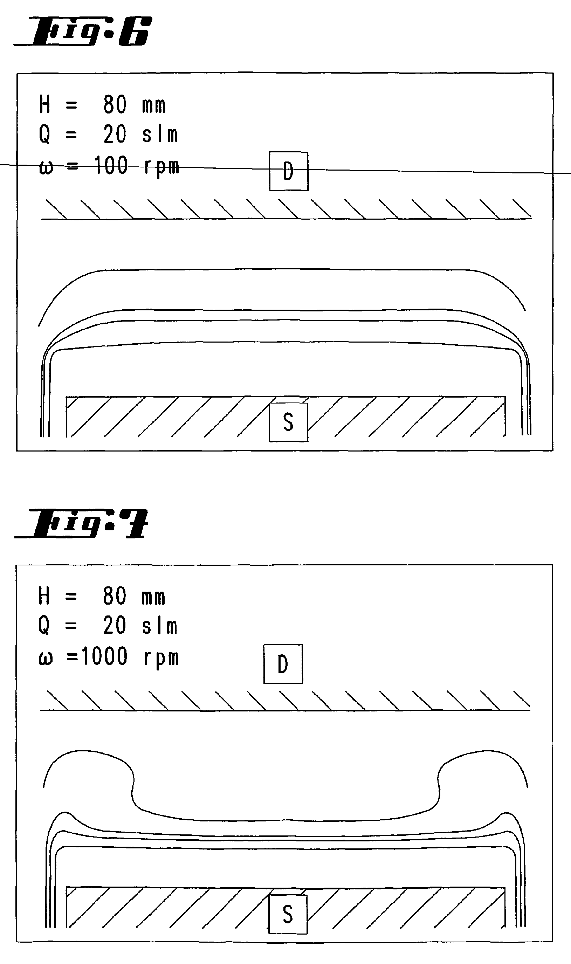

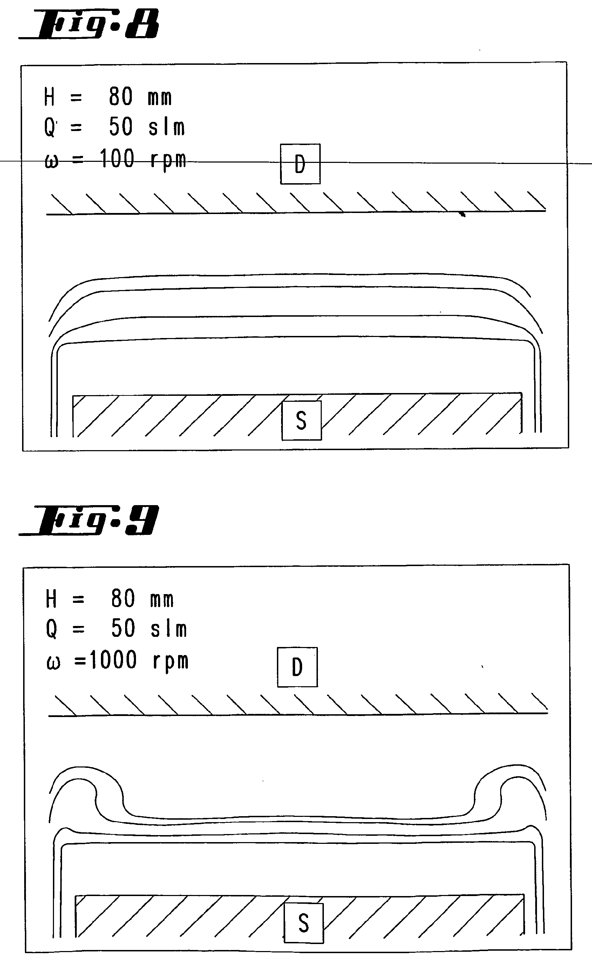

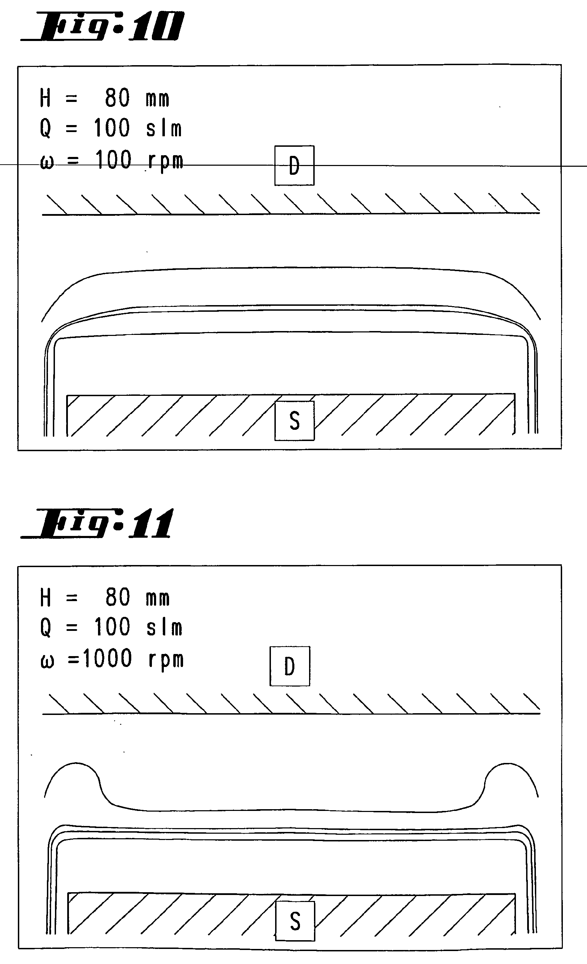

Die in den Figuren 6 bis 11 dargestellten Isothermenverläufe wurde für Prozesskammerhöhen von 80 mm berechnet. Man erkennt, dass der Totalgasfluss, der zwischen 20 slm und 100 slm variiert worden ist, einen geringen Einfluss auf die Isothermenhomogenität besitzt. Am Randbereich des mit S bezeichneten Substrathalters werden die Isothermenverläufe inhomogen. Brauchbare Werte werden bei einem Totalgasfluss von 50 slm und einer Substrathalterdrehzahl von 100 rpm erzielt. Die Substrathalterdrehzahl hat einen erheblichen Einfluss auf den Verlauf der Isothermen. Bei einer Substrathalterdrehzahl von 1000 rpm wird der Isothermenverlauf im Randbereich erheblich inhomogen und weicht sehr stark vom Isothermenbereich im Zentralbereich der Prozesskammer ab. Bei 80 mm Prozesskammerhöhe kann die Substrathalterdrehzahl nur in einem engen Bereich um 100 rpm und der Totalgasfluss nur in einem engen Bereich um 50 slm variiert werden. Die Untersuchungen wurden für Wasserstoff als Trägergas durchgeführt. Verwendet man Helium oder Stickstoff, so ergeben sich aufgrund der anderen Viskosität dieses Gases andere optimale hydromechanische Prozessparameter. Die optimalen Parametersätze sollten aber bei einer gleichen Reynoldszahl auftreten. Ebenso wird die gasmechanische Eigenschaft bei Variation der Prozesstemperatur im Bereich zwischen 500°C und 1200°C auf die gleiche Reynoldszahl eingestellt.

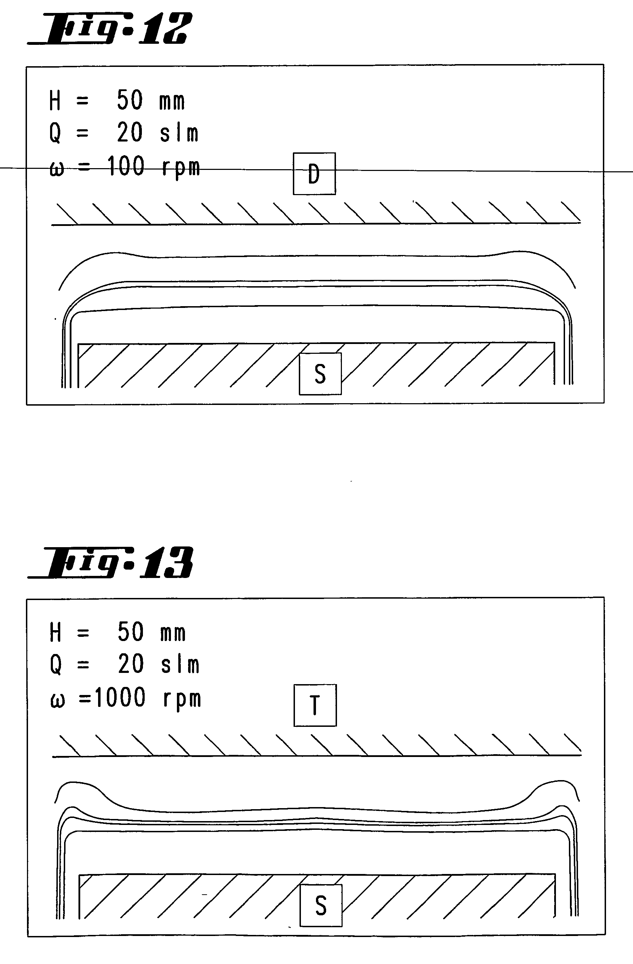

Die in den Figuren 12 bis 17 dargestellten Ergebnisse betreffen Prozesskammerhöhen von 50 mm. Der Totalgasfluss wurde hier in einem Bereich zwischen 20 und 100 slm variiert. Die Variation der Substrathalterdrehzahl fand in einem Bereich zwischen 100 und 1000 rpm statt. Hier zeigt sich nur noch ein Einfluss über den Totalgasstrom im kritischen Niedrigstrombereich. Oberhalb von 20 slm ist der Einfluss des Totalgasflusses nahezu Null. Auch hier zeigt sich ein gewisser Einfluss des Totalgasstromes und der Substrathalterdrehzahl auf den Verlauf der Isothermen, insbesondere am Rand des Substrathalters. Der Einfluss des Totalgasflusses ist aber geringer, als bei den in Figuren 6 bis 11 gezeigten Ergebnissen.

Ebenso ist der Einfluss der Substrathalterdrehzahl geringer, als bei einer Prozesskammerhöhe von 80 mm. Die Reduzierung der Prozesskammerhöhe von 80 mm auf 50 mm hat zur Folge, dass die übrigen Prozessparameter wie Totalgasfluss und Substrathalterdrehzahl in doch größerem Maße variiert werden können. Die Werte für den Totalgasfluss können im Bereich eines Faktors drei und die Substrathalterdrehzahl im Bereich eines Faktors 10 variiert werden.

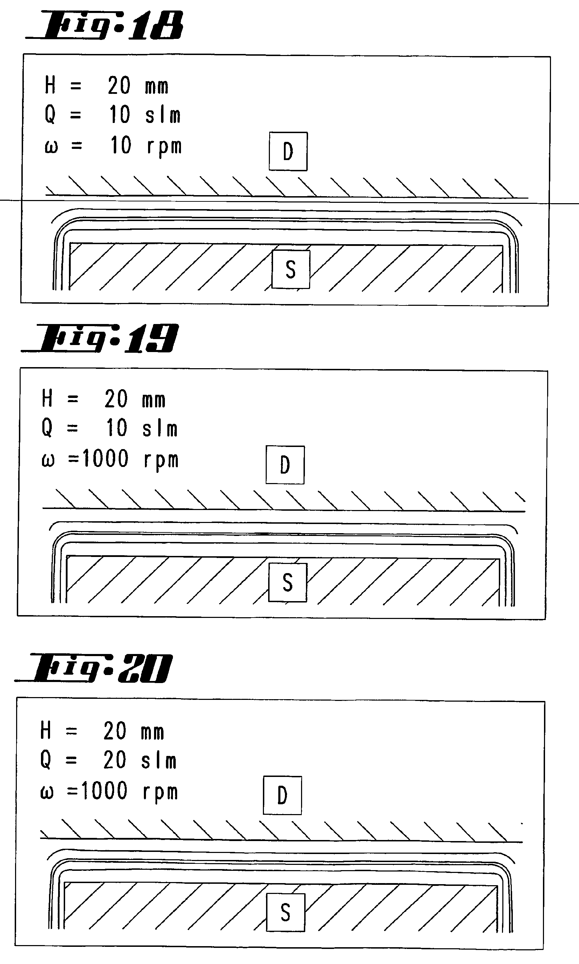

Die in den Figuren 18 bis 23 dargestellten Ergebnisse wurden bei einer Prozesskammerhöhe von 20 mm gewonnen. Hier wurde der Totalgasfluss in einem Bereich zwischen 20 und 50 slm und die Substrathalterdrehzahl in einem Bereich zwischen 10 und 1000 rpm variiert. Aus den Darstellungen ist deutlich zu ersehen, dass der Totalgasfluss so gut wie keinen Einfluss auf den Isothermenverlauf am Rand des Substrathalters besitzt. Auch die Substrathalterdrehzahl besitzt kaum einen Einfluss auf den Verlauf der Isothermen. Bei diesen Parametern können Totalgasfluss und Substrathalterdrehzahl in einem erheblich größeren Bereich variiert werden. Der Totalgasfluss kann durchaus in einem Bereich eines Faktors > 5 und die Substrathalterdrehzahl in einem Bereich eines Faktors > 10 variiert werden.

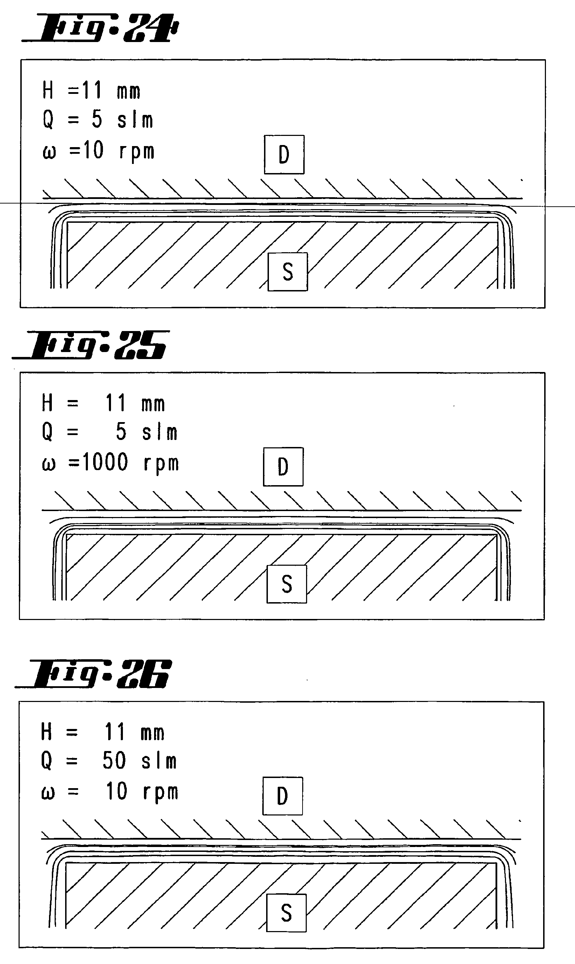

Die in den Figuren 24 bis 29 gezeigten Ergebnisse wurden bei einer Prozesskammerhöhe von 11 mm gewonnen. Hier wurde der Gesamtgasfluss in einem Bereich zwischen 5 slm und 50 slm variiert**.** Die Substrathalterdrehzahl wurde ebenfalls in einem Bereich von 10 bis 100 rpm variiert. Es ist kein Einfluss dieser Parameter auf den Isothermenverlauf festzustellen. Dies bedeutet, dass bei einer Prozesskammerhöhe von nur 11 mm der Totalgasfluss Bereich mindestens eines Faktors 10 variiert werden kann. Die Substrathalterdrehzahl lässt sich sogar Bereich eines Faktors 100 variieren, ohne dass sich der Isothermenverlauf ändert. Die Isothermen verlaufen über die gesamte Prozesskammer völlig flach.

Theoretisch lässt sich die Prozesskammerhöhe noch weiter verkleinern. Dies hat unterhalb einer Höhe von 11 mm aber kaum noch einen qualitätssteigernden Erfolg. Im Gegenteil. Es ist für die hydrodynamischen Verhältnisse im erheblichen Maße relevant, dass die Decke D der Prozesskammer völlig parallel verläuft zur Oberfläche des Substrathalters S. Je geringer der Abstand zwischen der Prozesskammerdecke D und der Substrathalteroberfläche ist, um so bedeutender ist der Einfluss einer Abweichung von der Parallelen.

Eine ideale parallele Ausrichtung von Prozesskammerdecke und Substrathalteroberfläche lässt sich aus technischen Gründen aber nicht realisieren. Es ist deshalb durchaus von Vorteil, wenn man die Prozesskammerhöhe nicht niedriger als 10 mm wählt. Dies gilt für Substrathalterdurchmesser von 10 bis 35 cm. Bei größeren Substrathalterdurchmessern, also ab 40 cm kann es sogar erforderlich sein, die Prozesskammerhöhe auf Werte oberhalb von 10 mm zu zu limitieren, beispielsweise auf 20 mm. Die Prozesse werden in der Regel bei 750° C und bei typischen Totaldrucken zwischen 150 mbar und 1000 mbar, bevorzugt zwischen 200 und 500 mbar durchgeführt. Dabei wird in der Regel nur der Substrathalter beheizt. Die als Duschkopf ausgebildete Prozesskammerdecke D wird dagegen gekühlt, so dass an der Oberfläche der Prozesskammerdecke eine sehr hohe Wärmeaufnahme und -abführung erforderlich ist.

Eine Limitierung der Prozesskammerhöhe nach unten kann aber auch wegen der nicht zu vermeidenden Fertigungstoleranzen erforderlich sein. Diese, im Wesentlichen durch statistische Fluktuationen hervorgerufenen Abweichen führen dazu, dass der für die Praxis optimale Bereich der Prozesskammerhöhe insbesondere auch unter Berücksichtigung des Durchmessers des Substrathalters und der Viskosität des verwendeten Gases zwischen 10 und 75 mm betragen kann. Bevorzugt liegt die Prozesskammerhöhe aber in einem Bereich von weniger als 50, 40, 30, 25 oder 10 mm.

## Patentansprüche

1. Verfahren zum Abscheiden von mehrkomponentigen Halbleiterschichten auf mindestens einem Substrat mit folgenden Merkmalen:
- Es werden mindestens drei reaktive Prozessgase verwendet, um entweder einen dotierten zwei- oder mehrkomponentigen Mischkristall oder einen undotierten drei- oder mehrkomponentigen Mischkristall abzuscheiden;
- die reaktiven Prozessgase werden zusammen mit einem Trägergas mittelst eines gemeinsamen Gaseinlassorgans in eine Prozesskammer eingeleitet, in welcher sich auf einem Substrathalter das Substrat befindet;
- der Substrathalter wird beheizt;
- das Gaseinlassorgan besitzt eine Gasauslassfläche, die in der Art eines Siebes eine Vielzahl von Gasaustrittsöffnungen besitzt;
- der Substrathalter erstreckt sich parallel zur Gasauslassfläche in der Horizontalebene und ist um eine Vertikalachse drehangetrieben;
- der Abstand zwischen dem Substrathalter und der Gasauslassfläche ist nicht größer als 75 mm;
- die reaktiven Gase beinhalten mindestens eine metallorganische Verbindung und mindestens ein Hydrid;
- das Schichtwachstum wird durch die Diffusion der Prozessgase durch eine Diffusionsgrenzsicht zum Substrat limitiert;
**dadurch gekennzeichnet, dass**
- die in Horizontalrichtung über dem Substrathalter verlaufenden Isothermen **dadurch** flach gehalten werden,
- dass die Gasauslassfläche gekühlt wird und
- die hydromechanischen Prozessparameter so gewählt sind, dass bezogen auf Wasserstoff als Trägergas die Reynoldszahl der Strömung in der Prozesskammer einen durch folgende Parametersätze begrenzten Wert besitzen:
die Drehzahl des Substrathalters liegt in einem Bereich von Rₘᵢₙ = 10 rpm bis Rₘₐₓ = 2000 rpm
der Totaldruck liegt in einem Bereich zwischen 20 und 1000 mbar,
der Totalfluss liegt in einem Bereich zwischen 10 und 200 slm,
die Prozesstemperatur liegt in einem Bereich zwischen 500°C und 1200°C,
der Durchmesser des Substrathalters beträgt 10 bis 35 cm und die Prozesskammerhöhe ist größer als 10 mm oder
der Durchmesser des Substrathalters ist größer als 40 cm und die Prozesskammerhöhe ist größer als 20 mm.

2. Verfahren nach Anspruch 1, **dadurch gekennzeichnet, dass** der Substrathalter von einem ringförmigen Gasauslassorgan umgeben ist, von welchem eine Gasableitung zu einer Pumpe führt.

3. Verfahren nach einem der vorhergehenden Ansprüche, **dadurch gekennzeichnet, dass** die Halbleiterschichten III, V-Halbleiterschichten sind und in weiteren Verfahrensschritten die Halbleiterschichten zu LED's, Solarzellen, Laser-HBT's, HEMT's weiter verarbeitet werden.

4. Verfahren nach einem der vorhergehenden Ansprüche, **dadurch gekennzeichnet, dass** bei einer Substrattemperatur im Bereich zwischen 500°C und 1200°C oder insbesondere von etwa 750°C der Totalgasfluss bei einer Prozesskammerhöhe von 75 mm zwischen 30 und 100 slm liegt und die Substrathalterdrehzahl zwischen 100 und 1000 rpm.

5. Verfahren nach einem der vorhergehenden Ansprüche, **dadurch gekennzeichnet, dass** bei einer Substrattemperatur im Bereich zwischen 500°C und 1200°C oder insbesondere von etwa 750°C der Totalgasfluss bei einer Prozesskammerhöhe von 50 mm zwischen 30 und 100 slm liegt und die Substrathalterdrehzahl zwischen 100 und 1000 rpm.

6. Verfahren nach einem der vorhergehenden Ansprüche, **dadurch gekennzeichnet, dass** bei einer Substrattemperatur im Bereich zwischen 500°C und 1200°C oder insbesondere von etwa 750°C der Totalgasfluss bei einer Prozesskammerhöhe von 20 mm zwischen 10 und 50 slm liegt und die Substrathalterdrehzahl zwischen 10 und 1000 rpm.

7. Verfahren nach einem der vorhergehenden Ansprüche, **dadurch gekennzeichnet, dass** bei einer Substrattemperatur im Bereich zwischen 500°C und 1200°C oder insbesondere von etwa 750°C der Totalgasfluss bei einer Prozesskammerhöhe von 11 mm weniger 50 slm beträgt und die Substrathalterdrehzahl zwischen 10 und 1000 rpm.

8. Verfahren nach einem der vorhergehenden Ansprüche, **dadurch gekennzeichnet, dass** der Abstand zwischen Substrathalter und Gasauslassfläche (Prozesskammerhöhe) kleiner als 50, 40, 30, 25, 20,16 oder 11 mm ist.

9. Verfahren nach einem der vorhergehenden Ansprüche, **dadurch gekennzeichnet, dass** der Abstand zwischen Substrathalter und Gasauslassfläche (Prozesskammerhöhe) größer als 11, 15 oder 20 mm ist.

10. Verfahren nach einem der vorhergehenden Ansprüche, **dadurch gekennzeichnet, dass** der Durchmesser des Substrathalters dem Durchmesser der Gasauslassfläche entspricht und größer ist als 10, 20, 30, 35, 40, oder 45 cm.

## Claims

1. Process for depositing multicomponent semiconductor layers on at least one substrate, comprising the following features:
- at least three reactive process gases are used, in order to deposit either a doped mixed crystal with two or more components or an undoped mixed crystal with three or more components;
- the reactive process gases are introduced, together with a carrier gas, by means of a common gas inlet member, into a process chamber, in which the substrate is located on a substrate holder;
- the substrate holder is heated;
- the gas inlet member has a gas outlet surface, which has a multiplicity of gas exit openings, in the manner of a sieve;
- the substrate holder extends parallel to the gas outlet surface in the horizontal plane and is driven in rotation about a vertical axis;
- the distance between the substrate holder and the gas outlet surface is not greater than 75 mm;
- the reactive gases contain at least one metalorganic compound and at least one hydride;
- the layer growth is limited by the diffusion of the process gases through a diffusion boundary layer to the substrate;
**characterized in that**
- the isotherms extending in a horizontal direction over the substrate holder are kept flat by
- the gas outlet surface being cooled, and
- the hydrometric process parameters being selected so that, based on hydrogen as carrier gas, the Reynolds number of the flow in the process chamber has a value delimited by the following parameter sets:
the rotational speed of the substrate holder is in a range from Rₘᵢₙ=10 rpm to Rₘₐₓ=2 0 0 0 rpm,
the total pressure is in a range between 20 and 1000 mbar,
the total flow is in a range between 10 and 200 slm,
the process temperature is in a range between 500°C and 1200°C,
the diameter of the substrate holder is 10 to 35 cm and the process chamber height is greater than 10 mm, or
the diameter of the substrate holder is greater than 40 cm and the process chamber height is greater than 20 mm.

2. Process according to claim 1, **characterized in that** the substrate holder is surrounded by an annular gas outlet member, from which a gas discharge line leads to a pump.

3. Process according to one of the preceding claims, **characterized in that** the semiconductor layers are III, V semiconductor layers, and in further process steps the semiconductor layers are processed further to form LEDs, solar cells, laser HBTs and HEMTs.

4. Process according to one of the preceding claims, **characterized in that** at a substrate temperature in the range between 500°C and 1200°C or in particular of approximately 750°C, the total gas flow, for a process chamber height of 75 mm, is between 30 and 100 slm, and the substrate holder rotational speed is between 100 and 1000 rpm.

5. Process according to one of the preceding claims, **characterized in that** at a substrate temperature in the range between 500°C and 1200°C or in particular of approximately 750°C, the total gas flow, for a process chamber height of 50 mm, is between 30 and 100 slm and the substrate holder rotational speed is between 100 and 1000 rpm.

6. Process according to one of the preceding claims, **characterized in that** at a substrate temperature in the range between 500°C and 1200°C, or in particular of approximately 750°C, the total gas flow, for a process chamber height of 20 mm, is between 10 and 50 slm and the substrate holder rotational speed is between 10 and 1000 rpm.

7. Process according to one of the preceding claims, **characterized in that** at a substrate temperature in the range between 500°C and 1200°C, or in particular of approximately 750°C, the total gas flow, for a process chamber height of 11 mm, is less than 50 slm, and the substrate holder rotational speed is between 10 and 1000 rpm.

8. Process according to one of the preceding claims, **characterized in that** the distance between substrate holder and gas outlet surface (process chamber height) is less than 50, 40, 30, 25, 20, 16 or 11 mm.

9. Process according to one of the preceding claims, **characterized in that** the distance between substrate holder and gas outlet surface (process chamber height) is greater than 11, 15 or 20 mm.

10. Process according to one of the preceding claims, **characterized in that** the diameter of the substrate holder corresponds to the diameter of the gas outlet surface and is greater than 10, 20, 30, 35, 40 or 45 cm.

## Revendications

1. Procédé de dépôt de couches de semi-conducteur à plusieurs composants sur au moins un substrat, présentant les caractéristiques suivantes :
- au moins trois gaz de processus réactifs sont utilisés pour déposer un cristal mixte dopé à deux composants ou plus ou un cristal mixte non dopé à trois composants ou plus ;
- les gaz de processus réactifs sont introduits conjointement avec un gaz vecteur, au moyen d'un organe commun d'introduction de gaz, dans une chambre de processus dans laquelle se trouve le substrat placé sur un porte-substrat;
- le porte-substrat est chauffé ;
- l'organe d'introduction de gaz comporte un surface de sortie de gaz qui possède une pluralité d'ouvertures de sortie de gaz à la manière d'un tamis ;
- le porte-subtrat s'étend dans le plan horizontal parallèlement à la surface de sortie de gaz et est entraîné en rotation autour d'un axe vertical ;
- la distance entre le porte-substrat et la surface de sortie de gaz n'est pas supérieure à 75 mm ;
- les gaz réactifs contiennent au moins un composé organométallique et au moins un hydrure ;
- la croissance des couches est limitée par la diffusion des gaz de processus vers le substrat à travers une couche limite ;
**caractérisé en ce que**
- les isothermes s'étendant dans une direction horizontale au-dessus du porte-substrat sont maintenus plats en raison du fait que
- la surface de sortie de gaz est refroidie et
- les paramètres de processus hydromécaniques sont choisis de telle sorte que, par rapport à l'hydrogène utilisé en tant que gaz vecteur, le nombre de Reynolds de l'écoulement dans la chambre de processus a une valeur limitée par l'ensemble de paramètres suivant :
la vitesse de rotation du porte-substrat est comprise dans une plage de Rₘᵢₙ = 10 tours par minute à Rₘₐₓ = 2000 tours par min,
la pression totale est dans une plage comprise entre 20 et 1000 mbar,
le débit total est dans une plage comprise entre 10 et 200 litres standard par minute (slm),
la température de processus est dans une plage comprise entre 500°C et 1200°C,
le diamètre du porte-substrat est de 10 à 35 cm et la hauteur de la chambre de processus est supérieure à 10 mm ou
le diamètre du porte-substrat est supérieure à 40 cm et la hauteur de la chambre de processus est supérieure à 20 mm.

2. Procédé selon la revendication 1, **caractérisé en ce que** le porte-substrat est entouré par un organe annulaire de sortie de gaz duquel part une conduite de gaz en direction d'une pompe.

3. Procédé selon l'une des revendications précédentes, **caractérisé en ce que** les couches de semi-conducteur sont des couches de semi-conducteur III, V et, dans d'autres étapes de procédé, les couches de semi-conducteur sont en outre traitées pour former des LEDs, des lasers HBT, des HEMT.

4. Procédé selon l'une des revendications précédentes, **caractérisé en ce que**, lorsque la température du substrat est dans la plage comprise entre 500°C et 1200°C ou est notamment d'environ 750°C et que la hauteur de la chambre de processus est de 75 mm, le débit total des gaz est compris entre 30 et 100 slm et la vitesse de rotation du porte-substrat est comprise entre 100 et 1000 tours par min.

5. Procédé selon l'une des revendications précédentes, **caractérisé en ce que**, lorsque la température du substrat est dans la plage comprise entre 500°C et 1200°C ou est notamment d'environ 750°C, et que la hauteur de la chambre de processus est de 50 mm, le débit total des gaz est compris entre 30 et 100 slm et la vitesse de rotation du porte-substrat est comprise entre 100 et 1000 tours par min.

6. Procédé selon l'une des revendications précédentes, **caractérisé en ce que**, lorsque la température du substrat est dans la plage comprise entre 500°C et 1200°C ou est notamment d'environ 750°C et que la hauteur de la chambre de processus est de 20 mm, le débit total des gaz est compris entre 10 et 50 slm et la vitesse de rotation du porte-substrat est comprise entre 10 et 1000 tours par min.

7. Procédé selon l'une des revendications précédentes, **caractérisé en ce que**, lorsque la température du substrat est dans la plage comprise entre 500°C et 1200°C ou est notamment d'environ 750°C et que la hauteur de la chambre de processus est de 11 mm, le débit total des gaz est inférieur à 50 slm et la vitesse de rotation du porte-substrat est comprise entre 10 et 1000 tours par min.

8. Procédé selon l'une des revendications précédentes, **caractérisé en ce que** la distance entre le porte-substrat et la surface de sortie de gaz (hauteur de la chambre de processus) est inférieure à 50, 40, 30, 25, 20, 16 ou 11 mm.

9. Procédé selon l'une des revendications précédentes, **caractérisé en ce que** la distance entre le porte-substrat et la surface de sortie de gaz (hauteur de la chambre de processus) est supérieure à 11, 15 ou 20 mm.

10. Procédé selon l'une des revendications précédentes, **caractérisé en ce que** le diamètre du porte-substrat correspond au diamètre de la surface de sortie de gaz et est supérieur à 10, 20, 30, 35, 40 ou 45 cm.
